# EUROPÄISCHE PATENTSCHRIFT

(11) **EP 1 661 048 B1**
(45) Veröffentlichungstag und Bekanntmachung des Hinweises auf die Patenterteilung: **28.12.2016**
(21) Anmeldenummer: 04762669.2
(22) Anmeldetag: 16.08.2004
(51) Int. Cl.: G06F 17/50

(54) **VERFAHREN ZUM ENTWURF VON INTEGRIERTEN SCHALTKREISEN MIT ERSATZ-LOGIKGATTERN**
METHOD FOR DESIGNING INTEGRATED CIRCUITS COMPRISING REPLACEMENT LOGIC GATES
PROCÉDÉ POUR CONCEVOIR DES CIRCUITS INTÉGRÉS COMPORTANT DES PORTES LOGIQUES DE SUBSTITUTION

(30) Priorität: 26.08.2003 DE 10339283
(43) Veröffentlichungstag der Anmeldung: 31.05.2006
(73) Patentinhaber: Infineon Technologies AG, 85579 Neubiberg (DE)
(72) Erfinder: DEPPE, Roswitha, 81735 München (DE); GEORGAKOS, Georg, 85447 Fraunberg (DE); SIEGLER, Sascha, 82008 Unterhaching (DE)
(74) Vertreter: Patentanwälte Lambsdorff & Lange
(86) Internationale Anmeldenummer: PCT/DE2004/001825
(87) Internationale Veröffentlichungsnummer: WO 2005/022629

(56) Entgegenhaltungen:
- WO-A-96/33495
- US-B1- 6 255 845
- US-B1- 6 321 371

## Beschreibung

Die Erfindung betrifft ein Verfahren zum Entwurf Re-Design-fähiger integrierter Schaltkreise, bei welchen Füllzellen Ersatz-Logikbausteine repräsentieren. Ferner betrifft die Erfindung ein Computerprogrammprodukt zum Ausführen des Entwurfsverfahrens, eine maschinenlesbare Zellbibliothek, einen Datenträger zum Speichern des Computerprogrammproduktes oder der Zellbibliothek, ein Computersystem zum Ausführen des Entwurfsverfahrens und einen integrierten Schaltkreis.

Beim Entwurf eines neuen integrierten Schaltkreises wird von der ersten Chipspezifikation bis zum einsatzbereiten Mikrochip eine wohldefinierte Abfolge von Entwurfsschritten durchlaufen, welche als "Design Flow" bezeichnet wird.

In einem ersten Entwurfsschritt wird die erwünschte LogikFunktionalität mit Hilfe von Hardware-Beschreibungssprachen wie VHDL (Very High Speed Hardware Description Language) beschrieben. Diese Entwurfsebene wird auch als RTL (Register Transfer Level) bezeichnet.

Im zweiten Entwurfsschritt wird die Netzliste synthetisiert. Sie beschreibt die Menge der den integrierten Schaltkreis bildenden logischen Zellen, und ihre Beschaltung.

Im nächsten Entwurfsschritt, dem Platzieren und Verdrahten (place and route), werden die den logischen Zellen zugeordneten Logikbausteine auf der Chip-Oberfläche platziert und die räumlichen Positionen der Zuleitungen festgelegt. Dazu werden sogenannte Füllzellen benutzt, die den für die Zuleitungen benötigten Platz zwischen den logischen Zellen ausfüllen.

Die Füllzellen werden auch als platzierte Füllzellen bezeichnet, da sie erst in der platzierten Netzliste, die das Endprodukt dieses Entwurfsschrittes darstellt, auftreten. Die platzierte Netzliste beschreibt das Schaltungslayout des integrierten Schaltkreises, meist im GDSII-Format (General Data Structure). Aus ihr können die Masken für die einzelnen Schritte des Herstellungsprozesses abgeleitet werden. Dieser kann in den sogenannten FEOL-(Front End Of Line) und den BEOL-Abschnitt (Back End Of Line) unterteilt werden, wobei der erste Abschnitt die Herstellung der Halbleiter-Bauelemente, der zweite das Aufbringen der Verdrahtungen bzw. der Metallisierungs-Schichten beschreibt.

Im Herstellungsprozess können Kosten und Zeit gespart werden, wenn Eigenschaften, die i.A. zu Beginn des "Design Flows" festgelegt werden, noch zu einem späten Zeitpunkt korrigiert werden können und somit die für die Korrekturen benötigten Iterationszyklen klein bleiben.

Der beim place and route-Entwurfsschritt mittels der Füllzellen für die Zuleitungen freigehaltene Platz kann anderweitig genutzt werden. Eine mögliche Vorgehensweise besteht darin, den Raum unterhalb der Zuleitungen im Bereich der Füllzellen als Kapazitäten aufzubauen. Solche als Kapazitäten realisierte Füllzellen werden zur Stabilisierung von Versorgungsspannungen genutzt.

Aus der Patentschrift US 6,321,371 B1 ist ein Verfahren zur Herstellung Re-Design-fähiger integrierter Schaltkreise bekannt. Dabei ist es möglich, logische Fehlfunktionen des integrierten Schaltkreises, verursacht durch einen Fehler im Design z.B. durch unvollständige Verifikation, mit Hilfe einer veränderten Verdrahtung zu korrigieren.

Die Re-Design-Fähigkeit wird dadurch erreicht, dass der Bereich der Füllzellen, im place and route-Entwurfsschritt mit zusätzlichen Halbleiter-Bauelementen gefüllt wird. Diese repräsentieren Ersatz-Logikbausteine ("spare logic gates"), die bei Bedarf - im Zuge eines Re-Designs - zum Einsatz kommen, um Fehlfunktionen der den logischen Zellen zugeordneten Logikbausteine zu korrigieren. Der notwendige Iterationszyklus zur Logikkorrektur beschränkt sich daher auf den BEOL-Abschnitt des Herstellungsprozesses.

Da die Wege zwischen den fehlerbehafteten Logikbausteinen und den korrigierend eingreifenden Ersatz-Logikbausteinen kurz sein sollen, wird eine möglichst große Anzahl von Füllzellen als Ersatz-Logikbaustein aufgebaut. Dadurch fallen unter Umständen die in den Füllzellen vorhandenen Kapazitäten, die zur Stabilisierung von Versorgungsspannungen genutzt wurden, weitestgehend weg.

Aus der den nächstliegenden Stand der Technik bildenden Druckschrift US 6,321,371 B1 ist es bekannt, Füllzellen vorzusehen, die Ersatz-Logikbausteine der integrierten Schaltung darstellen. Die Ersatz-Logikbausteine werden bei Bedarf im Rahmen eines Re-Designs der Metallisierungsschichten des integrierten Schaltkreises zum Ersatz von fehlerhaften Logikbausteinen herangezogen.

Der Druckschrift WO 96/33495 A1 ist die weiterführende Lehre zu entnehmen, solche Ersatz-Logikbausteine, die nicht zum Ersatz von fehlerhaften Logikbausteinen benötigt werden, in dem Re-Design-Schritt nachträglich als Stützkapazitäten zu beschalten. Durch diese Maßnahme können auch die im Nachhinein "überflüssigen" Ersatz-Logikbausteine noch sinnvoll eingesetzt werden, nämlich als Stützkapazitäten.

Aufgabe der Erfindung ist es, ein vereinfachtes Verfahren zum Entwurf von integrierten Schaltungen mit guten elektrischen Eigenschaften anzugeben. Ferner zielt die Erfindung darauf ab, ein Computerprogrammprodukt zur rechnergesteuerten Entwurfsunterstützung sowie einen Datenträger und ein Computersystem anzugeben.

Diese Aufgabe wird durch die Merkmale der unabhängigen Ansprüche gelöst.

Ein wesentlicher Aspekt der Erfindung besteht in der Erkenntnis, dass zur Korrektur von Fehlfunktionen der den logischen Zellen zugeordneten Logikbausteine nur ein Bruchteil der zur Verfügung stehenden Ersatz-Logikbausteine benötigt wird. Der größte Teil verbleibt in einem inaktiven Zustand, das heißt ein wesentlicher Anteil der Chip-Oberfläche bleibt ungenutzt, wenn er nicht in einem weiteren zeitaufwändigen Re-Design-Schritt neu beschaltet wird.

Ein Grundgedanke der vorliegenden Erfindung ist es, die kapazitiven Eigenschaften der inaktiven und somit ungenutzten Ersatz-Logikbausteine mit einem vereinfachten Verfahren gezielt zu nutzen. Durch eine geeignete Beschaltung bzw. Verdrahtung der verschieden dotierten Bereiche der Halbleiter-Bauelemente in den Füllzellen, die Ersatz-Logikbausteine repräsentieren, lassen sich deren kapazitive Eigenschaften nutzen. Hierfür bestehen prinzipiell zwei Möglichkeiten, je nachdem, wie die die Ersatz-Logikbausteine repräsentierenden Füllzellen in der Zellbibliothek definiert sind. Da Füllzellen erfindungsgemäß bereits als Kapazitäten beschaltet sind (d.h. sowohl Informationen bezüglich der Halbleiter-Struktur eines Logikbausteins als auch die Informationen bezüglich der kapazitiven Beschaltung derselben umfassen), ist lediglich der Schritt des Platzierens dieser "beschalteten" Füllzellen vorzunehmen. Sollten in der Zellbibliothek auch "unbeschaltete" Füllzellen (die lediglich Informationen bezüglich der Halbleiter-Struktur und gegebenenfalls noch Informationen hinsichtlich einer Basis-Metallisierung, nicht jedoch Informationen hinsichtlich der erfindungsgemäßen kapazitiven Beschaltung enthalten) vorliegen, muss die kapazitive Verdrahtung der verschiedenen dotierten Bereiche der Halbleiter-Struktur in einem weiteren Verfahrensschritt durchgeführt werden. Dieser Verfahrensschritt kann automatisiert oder durch Benutzerinteraktion erfolgen und insbesondere Teil eines sogenanntes (Metall-)Re-Design sein, in welchem die Verdrahtung der verschieden dotierten Bereiche innerhalb einer Zelle neu entworfen wird. Es wird darauf hingewiesen, dass die zweite Möglichkeit, welche einen weiteren Verfahrensschritt aufweist, in welchem Füllzellen, welche Ersatz-Logikbausteine für den integrierten Schaltkreis repräsentieren, nachträglich als Kapazität beschaltet werden, nicht Gegenstand des Anspruchs 1 ist.

Die damit zur Verfügung stehenden Kapazitäten können auf vielfältige Weise genutzt werden.

Eine vorteilhafte Ausgestaltung der Erfindung besteht darin, solche als Kapazität beschalteten Füllzellen, die Ersatz-Logikbausteine repräsentieren, zur Stabilisierung von Spannungen einzusetzen, das heißt, sie als Stützkapazitäten wirken zu lassen.

Stützkapazitäten befinden sich im Allgemeinen in unmittelbarer Nähe der Verbraucher. Die Induktivitäten der Zuleitungen werden dadurch minimiert und hochfrequente Störungen können effektiv gefiltert werden.

In der vorliegenden Erfindung befinden sich Verbraucher und Stützkapazitäten auf einer Chip-Oberfläche. Dadurch gelingt es, auch entsprechend hochfrequente Störungen wie Schaltrauschen zu minimieren.

Eine (ursprünglich oder nachträglich) als Stützkapazität beschaltete Füllzelle, die einen Ersatz-Logikbaustein repräsentiert, ist mit zwei verschiedenen Potentialen verbunden und dient der Stabilisierung der entsprechenden Potentialdifferenz. Im einfachsten Fall liegt einer der Anschlüsse einer gegebenen Füllzelle, die einen Ersatz-Logikbaustein repräsentiert, an der Versorgungsspannung VDD, ein anderer Anschluss an Masse VSS.

Durch eine rauscharme Versorgungsspannung wird unter anderem ein wesentlicher Beitrag zum Rauschen von Entscheiderschwellen minimiert. Dadurch sinkt die Fehlerrate und die maximale Taktrate des integrierten Schaltkreises kann entsprechend erhöht werden.

In einer bevorzugten Ausführungsform des erfindungsgemäßen Verfahrens werden die Füllzellen, die Ersatz-Logikbausteine repräsentieren, standardmäßig als Stützkapazität beschaltet, wodurch eine maximale Gesamtkapazität zur Stabilisierung der jeweiligen Spannungen bereit gestellt wird.

Treten nach dem ersten Entwurf des integrierten Schaltkreises Fehler in der Logikfunktionalität auf, so kann die fehlerhafte Logik durch die Ersatz-Logikbausteine korrigiert werden. In einem Re-Design werden dazu die Verdrahtungen einzelner Füllzellen, die Ersatz-Logikbausteine repräsentieren und so beschaltet sind, dass sie Stützkapazitäten in dem integrierten Schaltkreis bilden, so angepasst, dass sie zum Logikbaustein umfunktioniert werden. Da von einem solchen Re-Design im Allgemeinen nur ein Bruchteil der Füllzellen, die Ersatz-Logikbausteine repräsentieren, betroffen ist, bleibt die Gesamtkapazität, die als Stützkapazität zur Verfügung steht, nahezu unverändert.

In einer weiteren bevorzugten Ausführungsform werden sämtliche Füllzellen mit Halbleiter-Bauelementen ausgestattet und repräsentieren somit Ersatz-Logikbausteine für den integrierten Schaltkreis. Im Falle eines Re-Designs werden somit minimale Wege zwischen einem fehlerhaften Logikbaustein und dem nächstliegenden Ersatz-Logikbaustein garantiert. Durch die standardmäßige Beschaltung als Stützkagazität wird aber sichergestellt, dass von den Füllzellen die maximale Gesamtkapazität zur Stabilisierung der Versorgungsspannungen bereitgestellt wird.

Durch das erfindungsgemäße Verfahren ist es möglich, Re-Design-fähige integrierte Schaltkreise mit effektiv stabilisierten Versorgungsspannungen zu entwerfen.

Neben dem Einsatz als Stützkapazitäten, ist auch die gezielte Nutzung von als Kapazität beschalteten Füllzellen, die Ersatz-Logikbausteine repräsentieren, als kapazitive Elemente für andere Funktionen, beispielsweise in Filteranordnungen, denkbar.

Durch das erfindungsgemäße Computerprogrammprodukt wird der Entwickler in die Lage versetzt, die vorstehend beschriebenen Verfahrensschritte maschinell und automatisiert auszuführen. Dabei wird während des Platzierens der Zellen auf der Chip-Oberfläche standardmäßig auf Füllzellen, die Ersatz-Logikbausteine repräsentieren und bereits als Kapazität verdrahtet bzw. beschaltet sind, zurückgegriffen. Ebenfalls denkbar ist es, Füllzellen, die Ersatz-Logikbausteine repräsentieren, per Definition aber keine Verdrahtung bzw. Beschaltung aufweisen, innerhalb eines Re-Design-Schritts mit eine Verdrahtung bzw. Beschaltung als Kapazität zu versehen. Dies kann standardmäßig, dass heißt automatisiert oder über einen Eingriff des Benutzers geschehen. Auch im Falle eines Re-Designs, bei welchem ein als Kapazität beschalteter Ersatz-Logikbaustein zum Logikbaustein umfunktioniert werden soll, kann ein Benutzer-eingriff durch den Entwickler vorgesehen sein. Weiterhin kann die Beschaltung von solchen zur Kapazität umfunktionierten Ersatz-Logikbausteinen zu Stützkapazitäten durch das Computerprogrammprodukt automatisch vorgenommen werden. Unter Computerprogrammprodukt wird dabei das Computerprogramm als handelbares Produkt verstanden, in welcher strukturellen (maschinenlesbar, interpretierbar, in Form von Eingabe- bzw. Steuerparametern, etc.) und physikalischen (auf einem computerlesbaren Datenträger, über ein Netz verteilt, etc.) Form auch immer.

Eine maschinenlesbare Zellbibliothek definiert eine oder mehrere Zellen zum Platzieren auf eine Chip-Oberfläche während des Entwurfs eines integrierten Schaltkreises, auf die beispielsweise mit einem Computerprogrammprodukt während eines Entwurfsverfahrens für integrierte Schaltkreise zugegriffen werden kann.

Die erfindungsgemäße maschinenlesbare Zellbibliothek enthält dabei wenigstens eine Zelle, die einen Ersatz-Logikbaustein für den integrierten Schaltkreis repräsentiert, der als Kapazität beschaltet ist.

Ein nicht von der Erfindung umfasster integrierter Schaltkreis weist auf Grund des Vorhandenseins von Ersatz-Logikbausteinen sowie der kapazitiven Beschaltung derselben sowohl die gewünschte Re-Design-Fähigkeit als auch verbesserte elektrische Eigenschaften auf.

Nachfolgend werden anhand der Zeichnungen verschiedene Ausführungsbeispiele der Erfindung beschrieben. Es zeigen:
- Fig. 1: die Halbleiter-Struktur eines nicht verdrahteten Ersatz-Logikbaustein ohne Funktion;
- Fig. 2: eine Kapazität, gebildet durch den Anschluss der n-Wanne 2 an die Versorgungsspannung VDD und des p-Diffusionsbereiches 3 an Masse VSS;
- Fig. 3: eine Kapazität, gebildet durch den Anschluss des n-Diffusionsbereiches 4 an die Versorgungsspannung VDD und des Substrats 1 an Masse VSS;
- Fig. 4: eine Kapazität, gebildet durch den Anschluss des n-Diffusionsbereiches 4 und der n-Wanne 2 an die Versorgungsspannung VDD und des Substrats 1 und des p-Diffusionsbereiches 3 an Masse VSS;
- Fig. 5: eine Kapazität, gebildet durch den Anschluss der Polysilizium-Gates 7 an die Versorgungsspannung VDD und des n-Diffusionsbereiches 4 an Masse VSS;
- Fig. 6: eine Kapazität, gebildet durch den Anschluss der Polysilizium-Gates 7 an die Versorgungsspannung VDD und des p- und n-Diffusionsbereiches 3, 4 an Masse VSS;
- Fig. 7: einen Logikbaustein mit Beschaltung als Stützkapazität;
- Fig. 8: einen Logikbaustein ohne Beschaltung; und
- Fig. 9: einen Logikbaustein mit Beschaltung als NAND-Gatter.

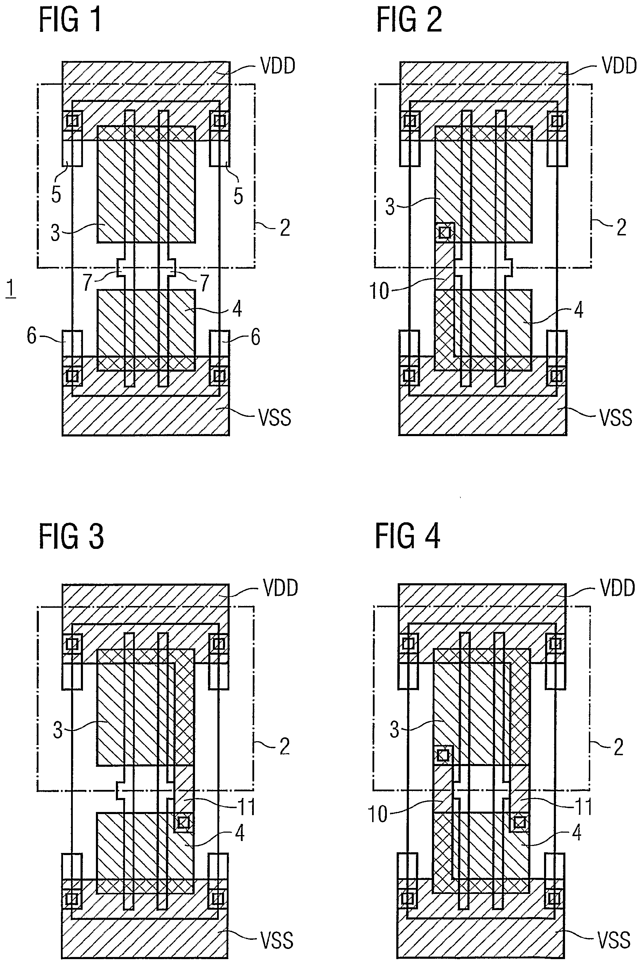

Fig. 1 zeigt die Grundstruktur, das heißt die Halbleiter-Struktur ohne Beschaltung, eines Ersatz-Logikbausteines bestehend aus 4 Transistoren. Im oberen Bereich der Figur ist eine n-Wanne 2 auf einem p-dotierten Substrat 1 dargestellt, innerhalb welcher sich ein p-Diffusionsbereich 3 mit darüber liegenden Gate-Elektroden (Polysilizium-Gates) 7 befindet. Diese Anordnung bildet zwei p-Kanal-MOSFETs, wobei sich beide Transistoren den mittleren Bereich des p-Diffusionsbereiches als gemeinsame Elektrode teilen. Im unteren Bereich der Figur ist in dem p-dotierten Substrat 1 ein n-Diffusionsbereich 4 mit darüber liegenden Gate-Elektroden 7 dargestellt. Diese Anordnung bildet zwei n-Kanal-MOSFETs. Am oberen bzw. unteren Rand der Figur sind jeweils Abschnitte der metallischen Leiterbahnen der Versorgungsspannung VDD bzw. der Masse VSS dargestellt, welche standardmäßig mit der n-Wanne 2 (über Anschluss 5) bzw. dem Substrat 1 (über Anschluss 6) verbunden sind.

Die Polysilizium-Gates 7 dienen als gemeinsame Gate-Elektrode für jeweils einen p- und einen n-Kanal-MOSFET. Durch entsprechende Beschaltung der Transistor-Elektroden können verschiedene Logikbausteine, d.h. Logikgatter (NAND, NOR, etc.) aufgebaut werden.

In den folgenden Figuren werden verschiedene Möglichkeiten, kapazitive Eigenschaften der verschieden dotierten Bereiche zu nutzen, dargestellt.

In Fig. 2 besteht die Kapazität im wesentlichen aus einem Kondensator, dessen erste Elektrode durch die n-Wanne 2 gebildet wird. Sie ist standardmäßig mit der Versorgungsspannung VDD verbunden. Die zweite Elektrode wird durch den p-Diffusionsbereich 3 gebildet, der über Anschluss 10 mit Masse VSS verbunden ist.

In Fig. 3 besteht die Kapazität ebenfalls im wesentlichen aus einem Kondensator, dessen erste Elektrode durch den n-Diffusionsbereich 4 gebildet wird und über Anschluss 11 mit der Versorgungsspannung VDD verbunden ist. Die zweite Elektrode wird durch das p-Substrat 1 gebildet, das standardmäßig mit Masse VSS verbunden ist.

Fig. 4 kombiniert die beiden vorherigen Ausführungsbeispiele. Die Kapazität besteht im wesentlichen aus zwei Kondensatoren.

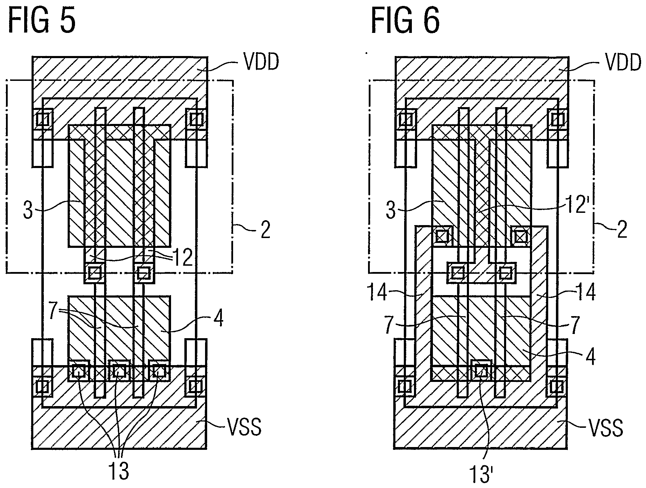

In Fig. 5 besteht die Kapazität aus mehreren Kondensatorelektroden. Mit der Versorgungsspannung VDD sind die Polysilizium-Gates 7 (über Anschluss 12) verbunden. Mit Masse VSS ist der n-Diffusionsbereich 4 (über Anschlüsse 13) verbunden.

Fig. 6 erweitert das Ausführungsbeispiel aus Fig. 5. Als Masseelektrode wird hier zusätzlich der p-Diffusionsbereich 3 (über Anschlüsse 14) genutzt. Mit der Versorgungsspannung VDD sind die Polysilizium-Gates 7 (über Anschluss 12') verbunden. Mit Masse VSS ist der mittlere Bereich des n-Diffusionsbereiches 4 (über Anschluss 13') verbunden.

Zudem sind noch eine Vielzahl weiterer Verdrahtungsmöglichkeiten denkbar, mit denen sich kapazitive Eigenschaften der verschieden dotierten Bereiche von Halbleiter-Bauelementen in Ersatz-Logikbausteinen nutzen lassen.

Die obigen Ausführungsbeispiele zeigen einen einfach aufgebauten Ersatz-Logikbaustein mit insgesamt 4 Transistoren. Die Erfindung erstreckt sich aber auch auf Ersatz-Logikbausteine beliebiger Komplexität. Insbesondere beinhalten komplexere Ersatz-Logikbausteine größere Dotierungsbereiche, womit sich größere Kapazitäten realisieren lassen.

Bei komplexen Ersatz-Logikbausteinen, welche eine Vielzahl von Halbleiter-Bauelementen enthalten, ist es zudem denkbar nur einen Teil des Ersatz-Logikbausteins zur Logikkorrektur des integrierten Schaltkreises zu nutzen, einen anderen Teil dagegen als Kapazität.

Im Zuge eines Re-Designs können verschiedene logischen Funktionen der Ersatz-Logikbausteine ausgewählt werden. Beispielsweise kann mit Hilfe des in den Ausführungsbeispielen gezeigten Ersatz-Logikbausteins mit je 2 n-Kanal- und p-Kanal-MOSFETs ein NAND- oder ein NOR-Gatter realisiert werden. Wird der Ersatzlogikbaustein dagegen als Inverter beschaltet, wird dazu nur ein Teil der Halbleiter-Bauelemente des Ersatz-Logikbausteins benötigt. Die übrigen Bereiche können weiterhin als Kapazität genutzt werden.

Weiterhin ist es denkbar, die kapazitiven Eigenschaften weiterer nicht genutzter Halbleiter-Bauelemente auf der Chip-Oberfläche zu nutzen. Im Zuge eines Re-Designs könnten dazu die verschieden dotierten Bereiche der fehlerhaften Halbleiter-Bauelemente innerhalb der betroffenen, logischen Zellen zugeordneten Logikbausteine entsprechend verdrahtet werden. Der Anteil der nicht genutzten Chip-Oberfläche kann auf diese Art und Weise minimiert werden.

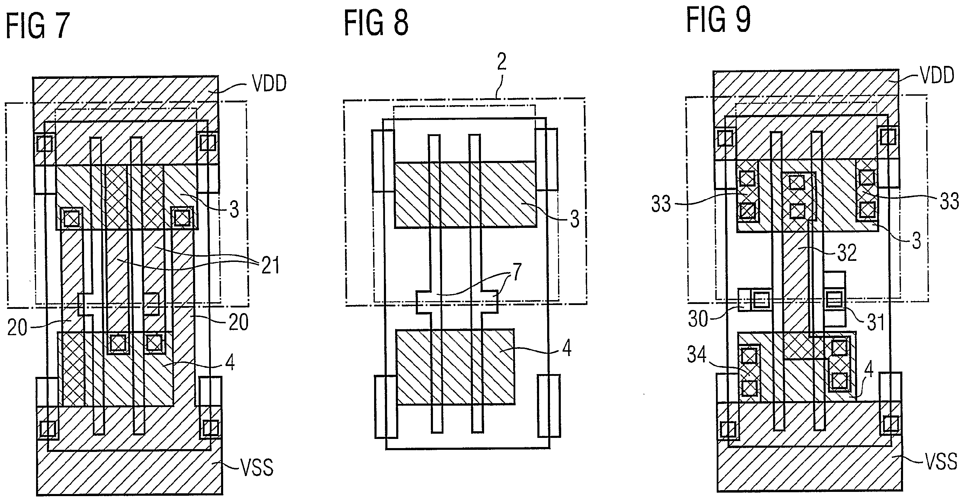

Die Fig. 7 - 9 zeigen den Ablauf eines Re-Designs. In Fig. 7 ist der Logikbaustein als Stützkapazität beschaltet. Der Aufbau der Kapazität entspricht dem der Kapazität aus Fig. 4. Der p-Diffusionsbereich 3 ist über die Zuleitungen 20 mit Masse VSS verbunden. Der n-Diffusionsbereich 4 ist über die Zuleitungen 21 mit der Versorgungsspannung VDD verbunden. In einem ersten Schritt des Re-Designs werden die Metallisierungsschichten (VDD, 20, 21, VSS) in der platzierten Netzliste entfernt. Nicht verändert wird die FEOL- bzw. Halbleiter-Struktur des Logikbausteins, wie n-Wanne 2 , p- bzw. n-Diffusionsbereich 3 bzw. 4, Polysilizium-Gates 7 (Fig. 8). In einem zweiten Schritt des Re-Designs werden neue Metallisierungsschichten (VDD, 30 - 34, VSS) in die platzierte Netzliste eingefügt und der Logikbaustein somit neu verdrahtet. In Fig. 9 werden die vier MOSFETs als NAND-Gatter beschaltet. Zuleitungen 30 und 31 bilden dabei die beiden logischen Eingänge des NAND-Gatters, Zuleitung 32 ist der logische Ausgang. Zuleitungen 33 verbinden die beiden parallel geschalteten p-Kanal-MOSFETs mit der Versorgungsspannung VDD, Zuleitung 34 verbindet die in Serie geschalteten n-Kanal-MOSFETs mit Masse VSS.

Der "Design-Flow" bzw. der Ablauf des Entwurfsprozesses wird mit Hilfe eines oder mehrerer Computerprogramme gesteuert. Das Computerprogramm wird dazu in den internen Speicher eines Computers geladen. Die Benutzerinteraktion findet über die üblichen Schnittstellen zur Eingabe (Tastatur, Maus, Datenströme mit Eingabedaten, etc.) bzw. Ausgabe (Monitor, Lautsprecher, Datenströme mit Ausgabedaten, etc.) statt. Die Ergebnisse der einzelnen Entwurfsschritte werden mit Hilfe des Computerprogrammproduktes erzeugt und ausgegeben.

## Patentansprüche

1. Computer-implementiertes Verfahren zum Entwurf eines integrierten Schaltkreises mit Ersatz-Logikbausteinen, mit dem Schritt:
- Platzieren einer Mehrzahl von logischen Zellen und einer Mehrzahl von Füllzellen, die Zwischenräume zwischen logischen Zellen füllen, auf einer Chipfläche, wobei zumindest einige der Füllzellen Ersatz-Logikbausteine für den integrierten Schaltkreis repräsentieren,
**dadurch gekennzeichnet, dass** zumindest einige der Ersatz-Logikbausteine in der Weise beschaltet sind, dass sie Kapazitäten (2, 3; 1, 4; 1, 2, 3, 4; 4, 7; 3, 4, 7) in dem integrierten Schaltkreis bilden.

2. Verfahren nach Anspruch 1, wobei
die Kapazitäten (2, 3; 1, 4; 1, 2, 3, 4; 4, 7; 3, 4, 7), die durch als Kapazität beschaltete Füllzellen, die Ersatz-Logikbausteine repräsentieren, gebildet werden, in dem integrierten Schaltkreis als Stützkapazitäten eingesetzt werden.

3. Verfahren nach Anspruch 1 oder 2, wobei
sämtliche platzierte Füllzellen, die Ersatz-Logikbausteine für den integrierten Schaltkreis repräsentieren, als Kapazitäten (2, 3; 1, 4; 1, 2, 3, 4; 4, 7; 3, 4, 7) beschaltet sind oder werden.

4. Verfahren nach Anspruch 1, 2 oder 3, wobei
sämtliche platzierte Füllzellen solche Füllzellen sind, die Ersatz-Logikbausteine für den integrierten Schaltkreis repräsentieren.

5. Verfahren nach einem der vorhergehenden Ansprüche, mit dem weiteren Schritt:
- Durchführen eines Re-Designs des Schaltungsentwurfs, bei welchem wenigstens eine der Füllzellen, die Ersatz-Logikbausteine repräsentieren und so beschaltet sind, dass sie Kapazitäten (2, 3; 1, 4; 1, 2, 3, 4; 4, 7; 3, 4, 7) in dem integrierten Schaltkreis bilden, durch eine Neubeschaltung (30-34) zum Logikbaustein des integrierten Schaltkreises umfunktioniert wird.

6. Computerprogrammprodukt, das in den internen Speicher eines Computers geladen werden kann und Computerprogramm-Code-Abschnitte umfasst, mit denen die Schritte nach einem der vorhergehenden Ansprüche ausgeführt werden.

7. Computersystem, insbesondere Computer oder Computernetzwerk, mit Mitteln zum Ausführen des Verfahrens nach einem der Ansprüche 1 bis 5.

## Claims

1. Computer-implemented method for designing an integrated circuit comprising spare logic components, comprising the step of:
- positioning a plurality of logic cells and a plurality of spacer cells - which fill interspaces between logic cells - on a chip area, at least some of the spacer cells representing spare logic components for the integrated circuit,
**characterized in that**
at least some of the spare logic components have been interconnected in such a way that they form capacitances (2, 3; 1, 4; 1, 2, 3, 4; 4, 7; 3, 4, 7) in the integrated circuit.

2. Method according to Claim 1, wherein
the capacitances (2, 3; 1, 4; 1, 2, 3, 4; 4, 7; 3, 4, 7) formed by spacer cells that represent spare logic components and are interconnected as capacitance are used as backup capacitances in the integrated circuit.

3. Method according to Claim 1 or 2, wherein
all of the positioned spacer cells that represent spare logic components for the integrated circuit have been or are interconnected as capacitances (2, 3; 1, 4; 1, 2, 3, 4; 4, 7; 3, 4, 7).

4. Method according to Claim 1, 2 or 3, wherein
all of the positioned spacer cells are such spacer cells that represent spare logic components for the integrated circuit.

5. Method according to one of the preceding claims, comprising the further step of:
- carrying out a redesign of the circuit design, in which at least one of the spacer cells that represent spare logic components and have been interconnected in such a way that they form capacitances (2, 3; 1, 4; 1, 2, 3, 4; 4, 7; 3, 4, 7) in the integrated circuit has its function changed by a reinterconnection (30-34) to form the logic component of the integrated circuit.

6. Computer program product which can be loaded into the internal memory of a computer and comprises computer program code sections by means of which the steps according to one of the preceding claims are executed.

7. Computer system, in particular computer or computer network, comprising means for executing the method according to one of Claims 1 to 5.

## Revendications

1. Procédé mis en oeuvre sur ordinateur pour concevoir un circuit intégré comportant des modules logiques de substitution, comportant l'étape consistant à :
- placer une pluralité de cellules logiques et une pluralité de cellules de remplissage qui remplissent les interstices entre les cellules logiques, sur une surface de puce, dans lequel au moins certaines cellules de remplissage représentent des modules logiques de substitution pour le circuit intégré, **caractérisé en ce qu'**au moins certains modules logiques de substitution sont interconnectés de manière à former des condensateurs (2, 3 ; 1, 4 ; 1, 2, 3, 4 ; 4, 7 ; 3, 4, 7) dans le circuit intégré.

2. Procédé selon la revendication 1, dans lequel les condensateurs (2, 3 ; 1, 4 ; 1, 2, 3, 4 ; 4, 7 ; 3, 4, 7), qui représentent les composants logiques de substitution par des cellules de remplissage interconnectées en tant que condensateurs, sont formés en étant utilisés dans le circuit intégré en tant que condensateurs auxiliaires.

3. Procédé selon la revendication 1 ou 2, dans lequel
l'ensemble des cellules de remplissage mises en place, qui représentent des modules logiques de substitution pour le circuit intégré, sont ou sont amenées à être interconnectées en tant que condensateurs (2, 3 ; 1, 4 ; 1, 2, 3, 4 ; 4, 7 ; 3, 4, 7).

4. Procédé selon la revendication 1, 2 ou 3, dans lequel
l'ensemble des cellules de remplissage mises en place sont les cellules de remplissage qui représentent des modules logiques de substitution pour le circuit intégré.

5. Procédé selon l'une quelconque des revendications précédentes, comportant l'étape supplémentaire consistant à :
- concevoir à nouveau le concept de circuit au moyen duquel au moins l'une des cellules de remplissage qui représentent les modules logiques de substitution et sont par conséquent connectées de manière à former des condensateurs (2, 3 ; 1, 4 ; 1, 2, 3, 4 ; 4, 7 ; 3, 4, 7) dans le circuit intégré, est reconfigurée par une nouvelle interconnexion (30-34) en un module logique du circuit intégré.

6. Produit de programme d'ordinateur pouvant être chargé dans la mémoire interne d'un ordinateur et comprenant des sections de code de programme d'ordinateur au moyen desquelles les étapes de l'une quelconque des revendications précédentes sont mises en oeuvre.

7. Système d'ordinateur, et plus particulièrement, ordinateur ou réseau d'ordinateurs, comportant des moyens destinés à mettre en oeuvre le procédé selon l'une quelconque des revendications 1 à 5.
